# EUROPÄISCHE PATENTSCHRIFT

(11) **EP 2 491 450 B1**
(45) Veröffentlichungstag und Bekanntmachung des Hinweises auf die Patenterteilung: **04.06.2014**
(21) Anmeldenummer: 10768487.0
(22) Anmeldetag: 20.10.2010
(51) Int. Cl.: G02B 26/08, G03B 21/14, H04N 9/31

(54) **MIKROMECHANISCHE PROJEKTIONSVORRICHTUNG SOWIE VERFAHREN ZUM HERSTELLEN EINER MIKROMECHANISCHEN PROJEKTIONSVORRICHTUNG**
MICROMECHANICAL PROJECTION DEVICE AND METHOD FOR PRODUCING A MICROMECHANICAL PROJECTION DEVICE
DISPOSITIF DE PROJECTION MICROMÉCANIQUE, ET PROCÉDÉ DE PRODUCTION D'UN DISPOSITIF DE PROJECTION MICROMÉCANIQUE

(30) Priorität: 22.10.2009 DE 102009045919
(43) Veröffentlichungstag der Anmeldung: 29.08.2012
(73) Patentinhaber: Robert Bosch GmbH, 70442 Stuttgart (DE)
(72) Erfinder: GRABMAIER, Florian, 72074 Tuebingen (DE)
(86) Internationale Anmeldenummer: PCT/EP2010/065798
(87) Internationale Veröffentlichungsnummer: WO 2011/048146

(56) Entgegenhaltungen:
- US-A1- 2002 067 533
- US-A1- 2005 056 701

## Beschreibung

### Stand der Technik

Die vorliegende Erfindung betrifft eine mikromechanische Projektionsvorrichtung sowie ein Verfahren zum Herstellen einer mikromechanischen Projektionsvorrichtung.

Eine solche mikromechanische Projektionsvorrichtung kann beispielsweise in einem tragbaren Gerät, wie einem Barcodescanner oder einem Mobiltelefon, verwendet werden, um ein Bild auf einer Projektionsfläche außerhalb des Geräts zu erzeugen. Ein mikromechanische Projektionsvorrichtung dieser Art ist beispielsweise in der DE 602 04 343 T2 beschrieben.

Eine der Anmelderin intern bekannte mikromechanische Projektionsvorrichtung weist einen verstellbaren Spiegel und eine Laser-Lichtquelle auf, welche in einem Aluminiumdruckgussgehäuse aufgenommen sind. Der Spiegel in Form eines mikromechanischen Chips ist in Bezug auf die Laser-Lichtquelle derart positioniert, dass ein von der Laserlichtquelle erzeugter Laser-Lichtstrahl auf dem Spiegel auftrifft und durch ein Fenster des Aluminiumdruckgussgehäuses auf eine Projektionsfläche projiziert wird.

Zum Zweck der Positionierung des Spiegels und der Laser-Lichtquelle zueinander ist das Aluminiumdruckgussgehäuse mit speziellen Aussparungen in seinem Inneren ausgebildet. In diesen Aussparungen sind der Spiegel und die Laser-Lichtquelle fixiert. Die elektrische Kontaktierung des Spiegels und der Laser-Lichtquelle mit einer Steuerungselektronik erfolgt über Drähte.

### Vorteile der Erfindung

Die in Anspruch 1 definierte erfindungsgemäße mikromechanische Projektionsvorrichtung und das in Anspruch 5 definierte Verfahren zum Herstellen einer mikromechanischen Projektionsvorrichtung bieten gegenüber herkömmlichen Lösungen den Vorteil, dass der zunächst ebene Träger montagetechnisch einfach mit dem Spiegel und der Lichtquelle bestückt werden kann. Hierfür ist beispielsweise ein simpler Portalroboter geeignet. Anschließend kann der zweite Abschnitt gebogen werden, um die gewünschte Position der Lichtquelle relativ zu dem Spiegel zu erzielen. Ferner ist es somit möglich, die arbeitsaufwändige Bestückung des Trägers an einem ersten Standort durchzuführen. Das anschließende Biegen des zweiten Abschnitts zum Zweck der genauen Positionierung der Lichtquelle und des Spiegels zueinander kann an einem zweiten Standort erfolgen, wo dieser vergleichsweise schwierige Prozess beherrscht wird bzw. entsprechende Geräte vorhanden sind, um die genaue Positionierung durchführen zu können.

Die in den jeweiligen Unteransprüchen aufgeführten Merkmale beziehen sich auf vorteilhafte Weiterbildungen und Verbesserungen des Gegenstandes der Erfindung.

Unter "mikromechanischer Projektionsvorrichtung" ist vorliegend eine Projektionsvorrichtung mit mikromechanischen Komponenten zu verstehen.

Gemäß einer bevorzugten Weiterbildung der Erfindung werden die elektronischen und/oder elektromechanischen Komponenten der mikromechanischen Projektionsvorrichtung, insbesondere der Spiegel und/oder die Lichtquelle, nach dem Aufbringen dieser auf den Träger, aber vor dem Biegen des zweiten Abschnitts auf ihre Funktionsfähigkeit hin getestet werden. Dies hat den Vorteil, dass ausschließlich funktionstüchtige Träger samt elektronischer und/oder elektromechanischer Komponenten dem aufwändigen Biegeprozess unterzogen werden. Fehlfunktionierende Träger und Komponenten, beispielsweise wegen fehlerhafter Lötstellen, können somit frühzeitig aussortiert werden, ohne weiteren, unnützen Aufwand in diese zu investieren.

Gemäß einer bevorzugten Weiterbildung der Erfindung werden die elektronischen und/oder elektromechanischen Komponenten der mikromechanischen Projektionsvorrichtung während des Biegens elektrisch betrieben werden. Mit "elektrisch betrieben" ist insbesondere gemeint, dass die Lichtquelle den Lichtstrahl erzeugt. Dies erleichtert die genaue Positionierung der Lichtquelle in Bezug auf den Spiegel.

### Zeichnungen

Ausführungsbeispiele der Erfindung sind in der Zeichnung dargestellt und in der nachfolgenden Beschreibung näher erläutert.

Es zeigen
- Fig. 1: in einer Seitenansicht eine mikromechanische Projektionsvorrichtung gemäß einem Ausführungsbeispiel der Erfindung;
- Fig. 2: in einer perspektivischen Ansicht der mikromechanischen Projektionsvorrichtung aus Fig. 1; und
- Fig. 3: eine Ansicht A aus Fig. 1 in vergrößerter Darstellung.

### Beschreibung von Ausführungsbeispielen

In den Figuren bezeichnen gleiche Bezugszeichen gleiche bzw. funktionsgleiche Elemente, soweit nichts Gegenteiliges angegeben ist.

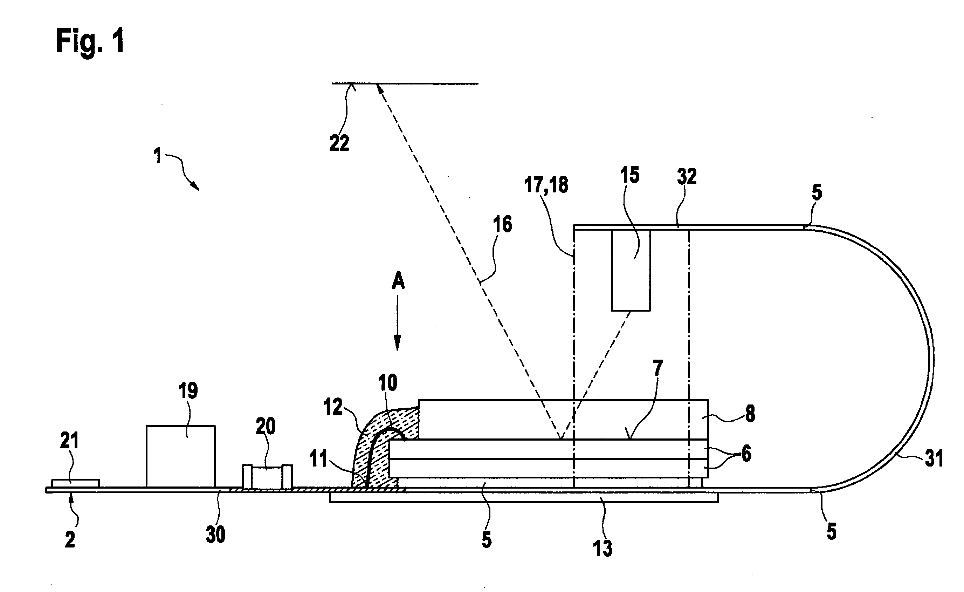

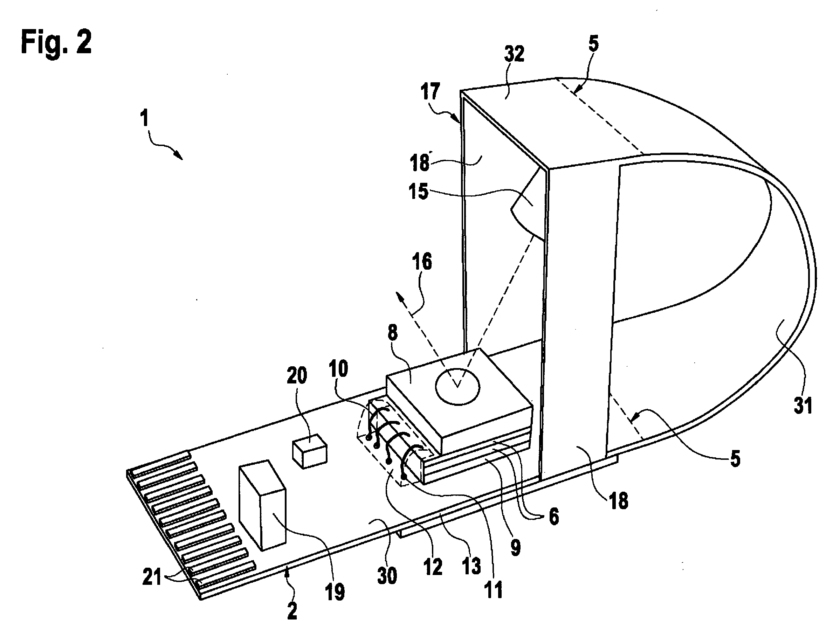

Fig. 1 zeigt in einer Seitenansicht eine mikromechanische Projektionsvorrichtung 1 gemäß einem Ausführungsbeispiel der Erfindung, Fig. 2 die Projektionsvorrichtung 1 in einer perspektivischen Ansicht.

Die Projektionsvorrichtung 1 weist einen Träger 2 auf. Der Träger 2 setzt sich aus einem im Wesentlichen ebenen, ersten Abschnitt 30, einem gebogenen, zweiten Abschnitt 31, und einem im Wesentlichen ebenen, dritten Abschnitt 32 zusammen. Gemäß dem vorliegenden Ausführungsbeispiel sind die drei Abschnitte 30, 31, 32 aus einem Stück biegsamer Leiterplatte ("Flexleiterplatte") ausgebildet. Es ist allerdings denkbar, die drei Abschnitte 30, 31, 32 aus unterschiedlichen Materialstücken, also beispielsweise aus einer biegsamen Leiterplatte und zwei steifen Leiterplatten, herzustellen und in Bereichen 5 zusammenzufügen. In diesem Fall wäre nur der zweite Abschnitt 31 aus biegsamen Material herzustellen.

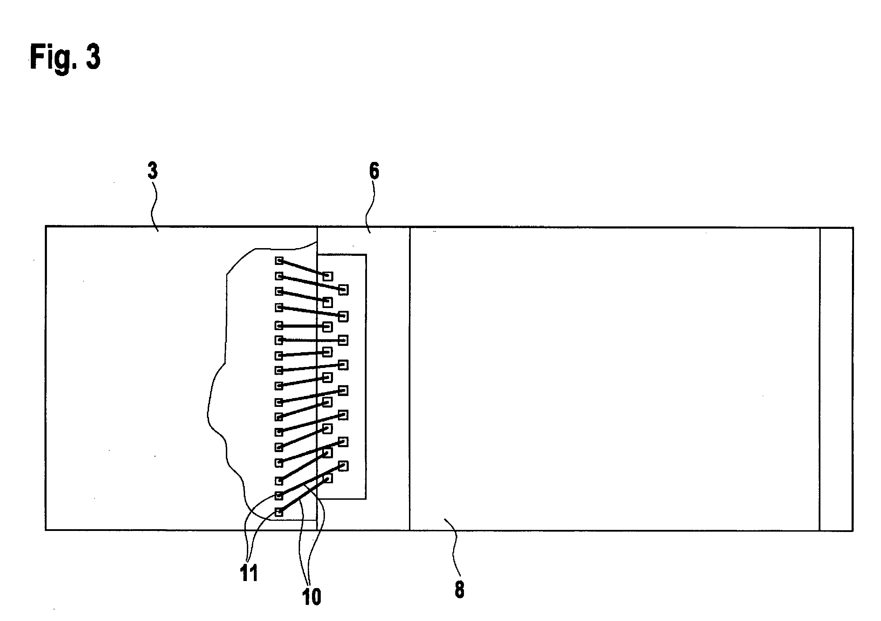

Auf dem ersten Abschnitt 30 ist ein Spiegel 6 aufgebracht, dessen Reflexionsfläche 7 verstellbar ist. Der Spiegel 6 ist vorzugsweise als mikromechanischer Chip (z.B. ein MEMS-Chip) ausgebildet. Der Spiegel 6 kann an seiner einen Seite mit einer Glasschicht 8 versehen sein, die ihn schützt. An seiner anderen Seite kann der Spiegel 6 auf einem Steuerchip 9, beispielsweise ein ASIC-Chip, aufgebracht sein. Der Steuerchip 9 steuert vorzugsweise unter anderem die Verstellung der Reflexionsfläche 7 und eine später noch näher erläuterten Lichtquelle. Der Spiegel 6 ist vorzugsweise mit Bonddrähten 10 versehen, welche auch in Fig. 3 zu sehen sind, die eine Ansicht A aus Fig. 1 zeigt. Die Bonddrähte 10 kontaktieren den Spiegel 6 mit Kontakten 11 nicht dargestellter Leiter des ersten Abschnitts 30. Um die Kontakte 11 sichtbar zu machen ist, ist der erste Abschnitt 30 teilweise geschnitten dargestellt. Auf die Bonddrähte 10 ist eine Glob-Top-Passivierung 12 aufgebracht. Der Steuerchip 9 ist vorzugsweise in Flip-Chip-Technik auf dem ersten Abschnitt 30 montiert.

Alternativ können der Spiegel 6 und der Steuerchip 9 auch nebeneinander auf dem ersten Abschnitt 30 aufgebracht sein. Weiterhin könnte der Spiegel 6 auf dem Steuerchip 9 ebenfalls in Flip-Chip-Technik montiert sein. In diesem Fall kann die erläuterte Kontaktierung mittels der Bonddrähte 10 entfallen.

Auf der dem Spiegel 6 abgewandten Seite des ersten Abschnitts 30 und dem Spiegel 6 im Wesentlichen gegenüberliegend ist vorzugsweise ein Versteifungselement 13 aufgebracht. Das Versteifungselement 13 versteift den Abschnitt 30, um die mechanische Belastung des Steuerchips 9 zu reduzieren. Insbesondere wirkt die Versteifung 13 dabei den aus der Biegung des zweiten Abschnitts 31 resultierenden Biegekräften entgegen. Die Versteifung 13 kann beispielsweise Metall, insbesondere Aluminium oder Edelstahl, oder Kunststoff aufweisen.

Der dritte Abschnitt 32 weist eine Lichtquelle 15 auf, die gemäß dem vorliegenden Ausführungsbeispiel als Laser-Lichtquelle ausgebildet ist. Die Lichtquelle 15 ist so positioniert, dass ein von ihr erzeugter Lichtstrahl 16 auf der Reflexionsfläche 7 des Spiegels 6 auftrifft. Dazu weist der zweite Abschnitt 31 eine in etwa halbkreisförmige Gestalt auf. Alternativ könnte er aber auch U-förmig oder lediglich L-förmig gestaltet sein oder eine dazwischenliegende Ausrichtung aufweisen. Ein Treiber, welcher die Lichtquelle 15 steuert, kann in den Steuerchip 9 integriert sein.

Der dritte Abschnitt 32 wird in Bezug auf den ersten Abschnitt 30 mittels eines Haltemittels 17 in Position gehalten. Das Haltemittel 17 ist in Fig. 1 mittels strichpunktierter Linie angedeutet. Das Haltemittel 17 besteht vorzugsweise aus zwei Halteabschnitten 18, die jeweils den dritten Abschnitt 32 mit dem ersten Abschnitt 30 im Bereich des Versteifungselements 13 verbinden, wie in Fig. 2 zu erkennen. Die Halteabschnitte 18 sind vorzugsweise jeweils an den gegenüberliegenden Schmalseiten der Abschnitte 30 und 32 befestigt, insbesondere verklebt.

Darüber hinaus können weitere elektrische Komponenten, wie beispielsweise ein Trafo 19 und ein Kondensator 20, auf dem ersten Abschnitt 30 aufgebracht sein. Ferner können Anschlüsse 21, beispielsweise an dem freien Ende des ersten Abschnitts 30, vorgesehen sein, mittels derer die Projektionsvorrichtung 1 mit weiteren Geräten elektrisch verbindbar ist.

Im Fall des vorliegenden Ausführungsbeispiels, bei welchem die Abschnitte 30, 31, 32 als Leiterplatte ausgebildet sind, sind selbstverständlich sind alle elektrischen Komponenten 6, 9, 15, 19, 20, 21 mit Leitern (nicht dargestellt) des ersten, zweiten bzw. dritten Abschnitts 30, 31 bzw. 32 elektrisch verbunden, insbesondere verlötet, auch wenn dies vorstehend nicht explizit beschrieben wurde.

Nachfolgend ist kurz das Funktionsprinzip der Projektionsvorrichtung 1 erläutert.

Die Lichtquelle 15 erzeugt den Lichtstrahl 16, welcher auf die Reflexionsfläche 7 des Spiegels 6 fällt und welcher von dieser auf eine Projektionsfläche 22 projiziert wird. Der Steuerchip 9 steuert den Spiegel 6 an, wobei dieser seine Reflexionsfläche 7 verstellt. Dies erfolgt in Abhängigkeit von Signalen, welche beispielsweise über die Anschlüsse 21 in den Steuerchip 9 eingekoppelt werden. Das Verstellen der Reflexionsfläche 7 und der damit verbundenen Bewegung des Lichtstrahls 16 auf der Projektionsfläche 22 erzeugt ein Bild auf dieser.

Abschließend wird ein Verfahren zum Herstellen der Projektionsvorrichtung 1 beschrieben.

In einem ersten Schritt wird der anfänglich im Wesentlichen ebene Träger 2 bereitgestellt.

In einem zweiten Schritt kann an dem ersten Abschnitt 30 des Trägers 2 unterseitig das Versteifungselement 13 angebracht werden, insbesondere aufgeklebt.

In einem dritten Schritt werden, beispielsweise mittels eines nicht dargestellten Portalroboters, die elektrischen und elektromechanischen Komponenten 9, 15, 19, 20, 21 bzw. 6 auf den jeweiligen Abschnitte 30 und 32 des Trägers 2 oberseitig positioniert und kontaktiert. Gemäß dem vorliegenden Ausführungsbeispiel wird dabei zunächst der Steuerchip 9 in Flipchiptechnik auf dem ersten Abschnitt 30 aufgebracht. Danach (aber auch gleichzeitig oder davor) können der Trafo 19, der Kondensator 20, die Anschlüsse 21 sowie etwaige weitere, nicht beschriebene elektrische Komponenten auf dem ersten Abschnitt 30 aufgebracht werden. Ferner wird die Lichtquelle 15 auf dem dritten Abschnitt 32 aufgebracht. Hiernach wird der Spiegel 6 auf den Steuerchip 9 gestacked und mittels der Kontaktdrähte 10 mit den Kontakten 11 des ersten Abschnitts 30 verbunden. Dann werden die freien Kontaktdrähte 10 mit Glob-Top vergossen.

Das hergestellte Zwischenprodukt, also der Träger 2 samt der elektrischen und elektromechanischen Komponenten 9, 15, 19, 20, 21 bzw. 6, wird in einem vierten Schritt auf seine Funktionsfähigkeit hin überprüft. Dazu kann eine geeignete, nicht dargestellte Prüfeinrichtung mit den Anschlüssen 21 verbunden werden und bestimmte Tests vornehmen. Zwischenprodukte, die Fehler aufweisen, können somit erkannt und aussortiert werden.

Vorzugsweise werden die Schritte eins bis vier an einem ersten Standort durchgeführt, da sie vergleichsweise arbeitsintensiv sind. Das geprüfte Zwischenprodukt wird daraufhin an einen zweiten Standort versandt, wo die nachstehenden Schritte erfolgen, welche ein gewisses Know-how erfordern.

In einem fünften Schritt wird der zweite Abschnitt 31 in etwa halbkreisförmig gebogen, vorzugsweise mittels einer nicht dargestellten Biegeeinrichtung. Während des Biegens sind die elektrischen und elektromechanischen Komponenten 9, 15, 19, 20, 21 bzw. 6 vorzugsweise in Betrieb geschaltet. Insbesondere sollte die Lichtquelle 15 so geschaltet sein, dass sie einen Lichtstrahl 16 erzeugt. Ist der zweite Abschnitt 31 weit genug gebogen, fällt der Lichtstrahl 16 auf die Reflektionsfläche 7 des Spiegels 6 und wird von dieser auf die Projektionsfläche 22 projiziert. Vorzugsweise misst eine nicht dargestellte Messeinrichtung die Position des Lichtstrahls 16 auf der Projektionsfläche 22 und gibt geeignete Signale an die Biegeeinrichtung, welche den zweiten Abschnitt 31 in Abhängigkeit von diesen Signalen so biegt, dass eine je nach Anforderungen optimale Position der Lichtquelle 15 gefunden wird.

In einem sechsten Schritt wird der dritte Abschnitt 32 mit dem ersten Abschnitt 30 verbunden. Hierzu werden die Halteabschnitte 18 des zuvor hergestellten Haltemittels 17 mit den Abschnitten 30 und 32 verbunden. Bei dem Haltemittel 17 kann es sich beispielsweise um ein Kunststoffteil handeln, welches bevorzugt im Spritzgussverfahren hergestellt wird.

Das Haltemittel 17 kann auch durch ein Gehäuse eines nicht dargestellten Geräts ausgebildet werden, in das die Projektionsvorrichtung 1 integriert sein kann. Damit ließen sich Bauteile einsparen.

Die für die Projektionsvorrichtung 1 beschriebenen vorteilhaften Ausgestaltungen sind auf das Verfahren zum Herstellen der Projektionsvorrichtung 1 entsprechend anwendbar und umgekehrt.

## Patentansprüche

1. Mikromechanische Projektionsvorrichtung (1), aufweisend:
einen Träger (2), welcher einen ersten, zweiten und dritten Abschnitt (30; 31; 32) aufweist, wobei der zweite Abschnitt (31) zwischen dem ersten und dritten Abschnitt (30; 32) liegt und biegsam ausgebildet ist;
einen Spiegel (6), welcher auf dem ersten Abschnitt (30) aufgebracht ist, wobei der Spiegel (6) als mikromechanischer Chip ausgebildet ist; und
eine Lichtquelle (15), die auf dem dritten Abschnitt (32) aufgebracht ist;
wobei der zweite Abschnitt (31) derart gebogen ist, dass ein Lichtstrahl (16) von der Lichtquelle (15) auf den Spiegel (6) richtbar ist,
**gekennzeichnet durch**
ein Haltemittel (17), welches den gebogenen, zweiten Abschnitt (31) und/oder den dritten Abschnitt (32) in Bezug auf den ersten Abschnitt (30) in Position hält.

2. Mikromechanische Projektionsvorrichtung nach Anspruch 1, wobei der zweite Abschnitt (31) in etwa halbkreis-, U- oder L-förmig gebogen ist.

3. Mikromechanische Projektionsvorrichtung nach Anspruch 1 oder 2, wobei wenigstens der zweite Abschnitt (31) als Flexleiterplatte ausgebildet ist.

4. Mikromechanische Projektionsvorrichtung nach einem der vorhergehenden Ansprüche, wobei ein Steuerchip (9) vorgesehen ist, welcher die Lichtquelle (15) und/oder den Spiegel (6) steuert, wobei der Steuerchip (9) zwischen dem ersten Abschnitt (30) und dem Spiegel (6) angeordnet ist.

5. Verfahren zum Herstellen einer mikromechanischen Projektionsvorrichtung (1), insbesondere einer mikromechanischen Projektionsvorrichtung nach einem der vorhergehenden Ansprüche, mit folgenden Schritten:
Bereitstellen eines im Wesentlichen ebenen Trägers (2);
Aufbringen eines Spiegels (6) auf einem ersten Abschnitt (30) des Trägers (2);
Aufbringen einer Lichtquelle (15) auf einem dritten Abschnitt (32) des Trägers;
Biegen eines zwischen dem ersten und dem dritten Abschnitt (30, 32) liegenden, zweiten Abschnitts (31) des Trägers (2) derart, dass ein Lichtstrahl (16) von der Lichtquelle (15) auf den Spiegel (6) richtbar ist; und
Verbinden des dritten Abschnitts (32) mit dem ersten Abschnitt (30) mittels eines Haltemittels (17).

6. Verfahren nach Anspruch 5, wobei elektronische und/oder elektromechanische Komponenten (9, 15, 19, 20, 21; 6), insbesondere der Spiegel (6) und/oder die Lichtquelle (15), nach dem Aufbringen dieser auf den Träger (2), aber vor dem Biegen des zweiten Abschnitts (31) auf ihre Funktionsfähigkeit hin getestet werden.

7. Verfahren nach Anspruch 5 oder 6, wobei elektronische und/oder elektromechanische Komponenten (9, 15, 19, 20, 21; 6), insbesondere der Spiegel (6) und/oder die Lichtquelle (15), nach dem Aufbringen dieser auf den Träger (2), während des Biegens elektrisch betrieben werden.

## Claims

1. Micromechanical projection device (1), having:
a carrier (2), which has a first, second and third portion (30; 31; 32), with the second portion (31) located between the first and third portions (30; 32) and having a flexible configuration;
a mirror (6), which is mounted on the first portion (30), with the mirror (6) being configured as a micromechanical chip; and
a light source (15), which is mounted on the third portion (32);
wherein the second portion (31) is bent such that a light beam (16) is directable from the light source (15) onto the mirror (6),
**characterized by**
a retaining means (17), which holds the bent, second portion (31) and/or the third portion (32) in position with respect to the first portion (30).

2. Micromechanical projection device according to Claim 1, wherein the second portion (31) is bent into the shape of approximately a semicircle, a U or an L.

3. Micromechanical projection device according to Claim 1 or 2, wherein at least the second portion (31) is configured as a flexible printed circuit board.

4. Micromechanical projection device according to one of the preceding claims, wherein a control chip (9) is provided, which controls the light source (15) and/or the mirror (6), wherein the control chip (9) is arranged between the first portion (30) and the mirror (6).

5. Method for manufacturing a micromechanical projection device (1), in particular a micromechanical projection device according to one of the preceding claims, having the following steps:
providing a substantially planar carrier (2);
mounting a mirror (6) on a first portion (30) of the carrier (2);
mounting a light source (15) on a third portion (32) of the carrier;
bending a second portion (31) of the carrier (2), located between the first and the third portion (30, 32), such that a light beam (16) is directable from the light source (15) onto the mirror (6); and
connecting the third portion (32) to the first portion (30) using a retaining means (17).

6. Method according to Claim 5, wherein electronic and/or electromechanical components (9, 15, 19, 20, 21; 6), in particular the mirror (6) and/or the light source (15), are tested as regards their function after they are mounted on the carrier (2), but before the second portion (31) is bent.

7. Method according to Claim 5 or 6, wherein electronic and/or electromechanical components (9, 15, 19, 20, 21; 6), in particular the mirror (6) and/or the light source (15), are electrically operated during bending after they are mounted on the carrier (2).

## Revendications

1. Dispositif micromécanique de projection (1), présentant :
un support (2) doté d'une première, d'une deuxième et d'une troisième partie (30; 31; 32), la deuxième partie (31) étant située entre la première et la troisième partie (30 ; 32) et étant flexible,
un miroir (6) appliqué sur la première partie (30), le miroir (6) étant configuré comme puce micromécanique et
une source de lumière (15) appliquée sur la troisième partie (32),
la deuxième partie (31) étant cintrée de telle sorte qu'un faisceau lumineux (16) provenant de la source de lumière (15) puisse être orienté sur le miroir (6),
**caractérisé par**
un moyen de maintien (17) qui maintient en position la deuxième partie cintrée (31) et/ou la troisième partie (32) par rapport à la première partie (30).

2. Dispositif micromécanique de projection selon la revendication 1, dans lequel la deuxième partie (31) est cintrée sensiblement en demi-cercle, en U ou en L.

3. Dispositif micromécanique de projection selon les revendications 1 ou 2, dans lequel au moins la deuxième partie (31) est configurée comme plaque conductrice flexible.

4. Dispositif micromécanique de projection selon l'une des revendications précédentes, qui présente une puce de commande (9) qui commande la source de lumière (15) et/ou le miroir (6), la puce de commande (9) étant disposée entre la première partie (30) et le miroir (6).

5. Procédé de fabrication d'un dispositif micromécanique de projection (1), en particulier d'un dispositif micromécanique de projection selon l'une des revendications précédentes, le procédé présentant les étapes suivantes :
préparation d'un support (2) essentiellement plat,
application d'un miroir (6) sur une première partie (30) du support (2),
application d'une source de lumière (15) sur une troisième partie (32) du support,
flexion d'une deuxième partie (31) du support (2) située entre la première et la troisième partie (30, 32) de telle sorte qu'un faisceau lumineux (16) provenant de la source de lumière (15) puisse être orienté sur le miroir (6) et
liaison de la troisième partie (32) à la première partie (30) au moyen d'un moyen de maintien (17).

6. Procédé selon la revendication 5, dans lequel le bon fonctionnement des composants électroniques et/ou électromécaniques (9, 15, 19, 20, 21; 6), en particulier le miroir (6) et/ou la source de lumière (15) est vérifié après leur application sur le support (2) mais avant la flexion de la deuxième partie (31).

7. Procédé selon les revendications 5 ou 6, dans lequel des composants électroniques et/ou électromécaniques (9, 15, 19, 20, 21; 6), en particulier le miroir (6) et/ou la source de lumière (15) sont alimentés en électricité pendant la flexion et après leur application sur le support (2).
